(19)

Europäisches
Patentamt
European
Patent Office
Office européen
des brevets

(11) **EP 4 625 802 A1**

(12) **EUROPEAN PATENT APPLICATION**
published in accordance with Art. 153(4) EPC

(43) Date of publication:
01.10.2025 Bulletin 2025/40

(21) Application number: 23925945.0

(22) Date of filing: 21.08.2023

(51) International Patent Classification (IPC):
*H02M 7/162* (2006.01)     *H02M 3/335* (2006.01)
*H02M 7/5387* (2007.01)     *H02M 1/088* (2006.01)
*G01R 27/02* (2006.01)

(86) International application number:
PCT/CN2023/113933

(87) International publication number:
WO 2024/183241 (12.09.2024 Gazette 2024/37)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 08.03.2023 CN 202310239127

(71) Applicant: Sungrow Power Supply Co., Ltd.
Hefei, Anhui 230088 (CN)

(72) Inventors:
• HOU, Peng
  Hefei, Anhui 230088 (CN)

• DU, Zelin
  Hefei, Anhui 230088 (CN)
• ZHU, Wanping
  Hefei, Anhui 230088 (CN)
• YU, Yanfei
  Hefei, Anhui 230088 (CN)
• YANG, Zongjun
  Hefei, Anhui 230088 (CN)

(74) Representative: Rooney, John-Paul
Withers & Rogers LLP
2 London Bridge
London SE1 9RA (GB)

(54) **CONVERTER AND INSULATION IMPEDANCE MEASUREMENT METHOD**

(57)     Disclosed in the present application are a converter and an insulation impedance measurement method. The converter comprises: a controller, a measurement resistor network and a power conversion circuit. The power conversion circuit comprises a first switch tube and a second switch tube, wherein a first end of the first switch tube is connected to a positive electrode of a direct-current power source, a second end of the first switch tube is connected to a first end of the second switch tube, a second end of the second switch tube is connected to a negative electrode of the direct-current power source, and the second end of the first switch tube is grounded by means of the measurement resistor network. The controller is used for obtaining an insulation impedance of the converter according to the voltage between the positive electrode and the negative electrode of the direct-current power source and the voltage to ground of the negative electrode of the direct-current power source before and after the first switch tube or the second switch tube is turned on. By means of controlling the state of a switch, the magnitude of the voltage between a positive electrode and a negative electrode of a direct current of the converter or the magnitude of a voltage to ground of the negative electrode of the direct current is changed, and in combination with an impedance of the measurement resistor network, an insulation impedance of the converter is obtained. The converter only requires the addition of a measurement resistor network, and the switch tubes of the converter are utilized, such that the cost is low.

**FIG. 1**

EP 4 625 802 A1

## Description

This application claims the priority to Chinese Patent Application No. 202310239127.8, titled "CONVERTER AND INSULATION IMPEDANCE MEASUREMENT METHOD", filed on March 08, 2023 with the China National Intellectual Property Administration, which is incorporated herein by reference in its entirety.

## FIELD

The present disclosure relates to the technical field of power electronics, and in particular to a converter and a method for detecting an insulation impedance.

## BACKGROUND

The clean energy represented by photovoltaic power generation and electrochemical energy storage systems, is increasingly applied. New energy power generation systems are generally deployed in outdoor environments and are thus susceptible to environmental conditions such as dust, rain, snow, and fog. Such conditions may result in variations of the insulation impedance to the ground, that is, the insulation impedance, of converters at the post stage of the new energy power generation systems (such as inverters). If the insulation impedance is too low, a leakage current may be produced, which may lead to a risk of electric shock. Therefore, it is necessary to perform real-time detection for the insulation impedance.

However, a conventional resistive bridge circuit is used to detect the insulation impedance in real-time, in which an additional resistor and a matched switching circuit to the ground is required. Thus, the device reliability will be reduced and the cost is increased.

## SUMMARY

In view of this, a converter and a method for detecting an impedance are provided in the present disclosure, to detect the insulation impedance of the converter accurately, improve the reliability and reduce the cost.

A converter is provided according to the present disclosure. The converter includes: a controller, a detection resistor network, and a power conversion circuit.

The power conversion circuit includes a first switch transistor and a second switch transistor.

A first terminal of the first switching device is connected to a positive electrode of a direct-current power supply, a second terminal of the first switching device is connected to a first terminal of the second switch transistor, and a second terminal of the second switch transistor is connected to a negative electrode of the direct-current power supply; and the second terminal of the first switch transistor is grounded through the detection resistor network.

The controller is configured to obtain an insulation impedance of the converter, based on a voltage between the positive electrode and the negative electrode of the direct-current power supply and a voltage between the negative electrode of the direct-current power supply and ground before and after the first switch transistor or the second switch transistor is turned on.

In an embodiment, the detection resistor network includes a first resistor; and the second terminal of the first switch transistor is grounded through the first resistor.

In an embodiment, the detection resistor network further includes: a second resistor and a third resistor.

Two terminals of the second resistor are respectively connected to the positive electrode of the direct-current power supply and the second terminal of the first switch transistor.

Two terminals of the third resistor are respectively connected to the negative electrode of the direct-current power supply and the second terminal of the first switch transistor.

In an embodiment, the converter further includes: an inductor; the second terminal of the first switch transistor is grounded, through the inductor and the first resistor connected in series.

In an embodiment, the controller is configured to obtain the insulation impedance of the converter, based on the voltage between the positive electrode and the negative electrode of the direct-current power supply and the voltage between the negative electrode of the direct-current power supply and the ground before the first switch transistor is turned on, and the voltage between the negative electrode of the direct-current power supply and the ground after the first switch transistor is turned on.

In an embodiment, the controller is configured to obtain the insulation impedance of the converter, based on the voltage between the positive electrode and the negative electrode of the direct-current power supply and the voltage between the negative electrode of the direct-current power supply and the ground before the second switch transistor is turned on, and the voltage between the negative electrode of the direct-current power supply and the ground after the second switch transistor is turned on.

In an embodiment, the converter is an isolated DCDC converter or an isolated DCAC converter.

The first switch transistor and the second switch transistor are two switch transistors in a first bridge arm of a full bridge at a primary side of the isolated DCDC converter or the isolated DCAC converter; and the full bridge at the primary side of the isolated DCDC converter includes the first bridge arm and a second bridge arm.

In an embodiment, the converter is a T-type three-level inverter.

The T-type three-level inverter further includes an inductor; and the second terminal of the first switch transistor is grounded through the inductor and the detection resistor network connected in series.

In an embodiment, the converter includes a three-level Boost circuit and a neutral-point clamped inverter circuit; the neutral-point clamped inverter circuit includes a first switching module, a second switching module, a third switching module, and a fourth switch module which are connected in series; and

The first switch transistor and the second switch transistor are a first switching module and a second switching module of the three-level Boost circuit, respectively.

Alternatively, the first switch transistor and the second switch transistor are the second switching module and the third switching module of the neutral-point clamped inverter circuit, respectively.

In an embodiment, the converter includes a three-level Boost circuit and an active neutral-point clamped inverter circuit; and the first switch transistor and the second switch transistor are a first switch transistor and a second switch transistor of the three-level Boost circuit, respectively.

In an embodiment, the converter is a bidirectional DCDC buck-boost converter; the bidirectional DCDC buck-boost converter includes a first switching module, a second switching module, a third switching module, and a fourth switching module which are sequentially connected in series.

The first switch transistor and the second switch transistor are the first switching module and the second switching module, respectively.

A common terminal of the first switching module and the second switching module is grounded through the detection resistor network.

In an embodiment, the converter is a heric converter; the heric converter includes a first bridge arm, a second bridge arm, a fifth switching module, a sixth switching module, and an LC filter; a midpoint of the first bridge arm is grounded through the detection resistor network.

The fifth switching module and the sixth switching module are connected in series between the midpoint of the first bridge arm and a midpoint of the second bridge arm.

A first terminal and a second terminal of the LC filter are connected to the midpoint of the first bridge arm and the midpoint of the second bridge arm, respectively; and the first terminal and the second terminal of the LC filter are connected to two terminals of a capacitor through a first inductor and a second inductor, respectively.

In an embodiment, the converter is a heric converter; the heric converter includes a first bridge arm, a second bridge arm, a fifth switching module, a sixth switching module, and an LC filter;

The fifth switching module and the sixth switching module are connected in series between a midpoint of the first bridge arm and a midpoint of the second bridge arm.

A first terminal and a second terminal of the LC filter are connected to the midpoint of the first bridge arm and the midpoint of the second bridge arm, respectively; and the first terminal and the second terminal of the LC filter are connected to two terminals of a capacitor through a first inductor and a second inductor, respectively.

The first terminal of the LC filter is grounded through the first inductor and the first resistor connected in series.

The first switch transistor and the second switch transistor are two switch transistors of the first bridge arm.

In an embodiment, the converter further includes: a switch; the detection resistor network is grounded through the switch.

The controller is further configured to control the switch to be turned on when the insulation impedance is detected, and control the switch to be turned off when the insulation impedance is not detected.

In an embodiment, the direct-current power supply is a photovoltaic array or a battery.

A method for detecting an insulation impedance of a converter is further provided according to the present disclosure. The converter includes: a detection resistor network and a power conversion circuit. The power conversion circuit includes a first switch transistor and a second switch transistor; a first terminal of the first switch transistor is connected to a positive electrode of a direct-current power supply, a second terminal of the first switch transistor is connected to a first terminal of the second switch transistor, and a second terminal of the second switch transistor is connected to a negative electrode of the direct-current power supply; and the second terminal of the first switch transistor is grounded through the detection resistor network.

The method further includes:

obtaining a voltage between the positive electrode and the negative electrode of the direct-current power supply and a voltage between the negative electrode of the direct-current power supply and ground, when both the first switch transistor and the second switch transistor are turned off;

turning on the first switch transistor or the second switch transistor; and

obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on.

In an embodiment, the detection resistor network includes a first resistor; and the second terminal of the first switch transistor is grounded through the first resistor.

In an embodiment, the detection resistor network further includes: a second resistor and a third resistor.

Two terminals of the second resistor are respectively connected to the positive electrode of the direct-current power supply and the second terminal of the first switch transistor.

Two terminals of the third resistor are respectively connected to the negative electrode of the direct-current power supply and the second terminal of the first switch transistor.

In an embodiment, the obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on includes:
obtaining the insulation impedance of the converter based on the voltage between the positive electrode and the negative electrode of the direct-current power supply and the voltage between the negative electrode of the direct-current power supply and the ground before the first switch transistor is turned on, and the voltage between the negative electrode of the direct-current power supply and the ground after the first switch transistor is turned on.

In an embodiment, the obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on includes:
obtaining the insulation impedance of the converter based on the voltage between the positive electrode and the negative electrode of the direct-current power supply and the voltage between the negative electrode of the direct-current power supply and the ground before the second switch transistor is turned on, and the voltage between the negative electrode of the direct-current power supply and the ground after the second switch transistor is turned on.

It can be seen that the present disclosure has the following beneficial effects.

In the converter according to the present disclosure, only one detection resistor network is required to be added to the converter. The topology of the converter already includes the first switch transistor and the second switch transistor connected in series, and the second terminal of the first switch transistor is grounded through the detection resistor network. By controlling the on/off state of the first switch transistor or the second switch transistor, the voltage between the direct-current positive electrode and the direct-current negative electrode of the converter or the voltage between the direct-current negative electrode and the ground can be changed, and then the insulation impedance of the converter can be obtained based on the impedance of the detection resistor network. The structure of the converter for detecting insulation impedance is simple, and only the detection resistor network is required to be added. The switch transistor of the power conversion circuit of the converter is utilized, so that the cost is low. The structure of the converter for detecting insulation impedance suitable for various types of converters.

**BRIEF DESCRIPTION OF THE DRAWINGS**

FIG. 1 is a schematic diagram of a converter according to an embodiment of the present disclosure;

FIG. 2 is a schematic diagram of a detection resistor network according to an embodiment of the present disclosure;

FIG. 3 is a schematic diagram illustrating that a first resistor is grounded according to an embodiment of the present disclosure;

FIG. 4 is a schematic diagram of a detection resistor network according to another embodiment of the present disclosure;

FIG. 5 is an equivalent circuit diagram corresponding to a situation that both switches in FIG. 2 are turned off;

FIG. 6A is an equivalent circuit diagram corresponding to a situation that S1 in FIG. 2 is turned on and S2 in FIG. 2 is turned off;

FIG. 6B is an equivalent circuit diagram corresponding to a situation that S1 in FIG. 2 is turned off and S2 in FIG. 2 is turned on;

FIG. 7 is a flowchart of a method for obtaining an insulation impedance of a converter according to an embodiment of the present disclosure;

FIG. 8A is a schematic diagram of an isolated DCDC converter according to an embodiment of the present disclosure;

FIG. 8B is a schematic diagram of an isolated DCDC converter according to another embodiment of the present disclosure;

FIG. 9 is a schematic diagram of an isolated DCAC converter according to an embodiment of the present disclosure;

FIG. 10 is a schematic diagram of a T-type three-level converter according to an embodiment of the present disclosure;

FIG. 11 is a schematic diagram of a three-level Boost+NPC converter according to an embodiment of the present disclosure;

FIG. 12 is a schematic diagram of a three-level Boost+NPC converter according to another embodiment of the present disclosure;

FIG. 13 is a schematic diagram of a three-level Boost+ANPC converter according to an embodiment of the present disclosure;

FIG. 14 is a schematic diagram of a bidirectional DCDC buck-boost converter according to an embodiment of the present disclosure;

FIG. 15 is a schematic diagram of a heric converter according to an embodiment of the present disclosure;

FIG. 16 is a schematic diagram of a heric converter according to another embodiment of the present disclosure;

FIG. 17 is a schematic diagram of a heric converter according to yet another embodiment of the present disclosure; and

FIG. 18 is a flowchart of a method for detecting an insulation impedance of a converter according to an embodiment of the present disclosure.

## DETAILED DESCRIPTION

In order to make the above objectives, features and advantages of the present disclosure more apparent and easier to be understood, the embodiments of the present disclosure are described in detail below in conjunction with the drawings and the embodiments.

The application scenario of the converter according to the embodiments of the present disclosure is not specifically limited, which may be photovoltaic power generation, energy storage, or other power electronics fields. Further, the specific type of the converter is not specifically limited in the embodiment of the present disclosure, which may be, for example, an isolated converter or a non-isolated converter. When the converter is the isolated converter, it may be an isolated direct-current to direct-current (DCDC) converter or an isolated direct-current to alternating-current (DCAC) converter. It should be understood that the insulation impedance obtained by the converter provided according to the embodiment of the present disclosure refers to the insulation impedance to ground on the direct-current side of the converter.

In order to facilitate understanding, a converter applied to a photovoltaic system is introduced below as an example.

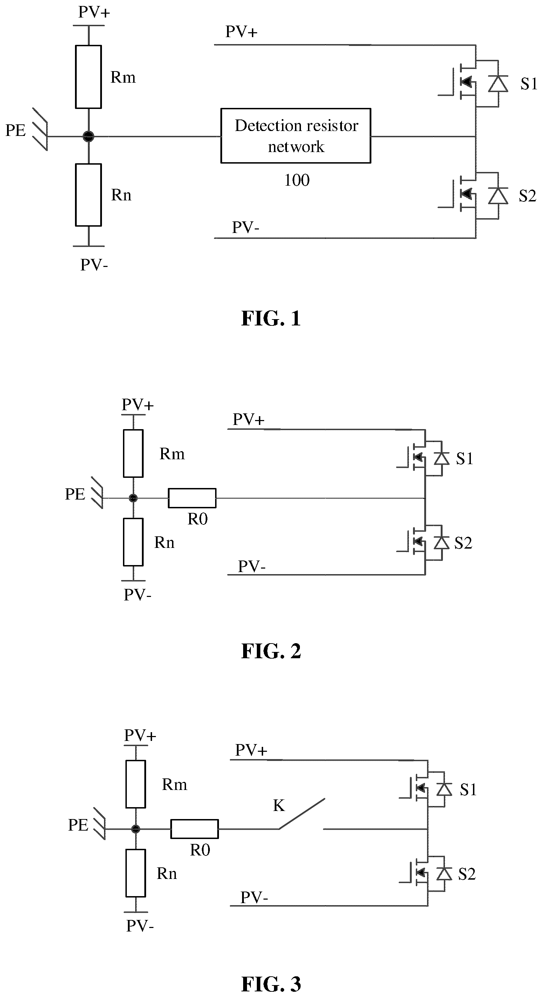

Referring to FIG. 1, a schematic diagram of a converter is shown according to an embodiment of the present disclosure.

An inverter according to an embodiment of the present disclosure includes: a controller (not shown in FIG. 1), a detection resistor network 100, and a power conversion circuit. The power conversion circuit includes a first switch transistor S1 and a second switch transistor S2.

A first terminal of the first switch transistor S1 is connected to a positive electrode PV+ of a direct-current power supply, a second terminal of the first switch transistor S1 is connected to a first terminal of the second switch transistor S2, and a second terminal of the second switch transistor S2 is connected to a negative electrode PV- of the direct-current power supply. The second terminal of the first switch transistor S1 is grounded through the detection resistor network 100.

In this embodiment, the direct-current power supply being a photovoltaic array is taken as an example for introduction.

The controller is configured to obtain an insulation impedance of the converter, based on an impedance of the detection resistor network 100, and a voltage between the positive electrode and the negative electrode of the direct-current power supply and a voltage between the negative electrode of the direct-current power supply and the ground before and after the first switch transistor is turned on or before and after the second switch transistor is turned on.

The number of resistors inside the detection resistor network 100 is not specifically limited in the embodiment of the present disclosure, which for example, may be one or more. For example, the detection resistor network 100 may include three resistors.

The scenarios in which the detection resistor network 100 includes one resistor and three resistors are respectively described below in combination with the drawings.

Referring to FIG. 2, a schematic diagram of a detection resistor network is shown according to an embodiment of the present disclosure.

In this embodiment, the detection resistor network including the first resistor R0 is taken as an example for description.

The second terminal of the first switch transistor S1 is grounded through the first resistor R0.

Referring to FIG. 3, a schematic diagram of a detection resistor network is shown according to an embodiment of the present disclosure. Instead of the switch transistors S1 and S2 shown in FIG. 2, the detection resistor network may be more switch transistors connected in series. FIG. 1 shows only a part circuit of the converter.

The source of S1 is connected to the drain of S2. Rm is an intrinsic impedance of the positive input terminal of the converter to the ground PE (casing), Rn is the intrinsic impedance of the negative terminal of the converter to the ground PE (casing). The resistance value of R0 is known, and R0 is connected between PE and the source terminal of S1 in series.

In addition, the converter may include: a switch K. Details may be referred to FIG. 3, which is a schematic diagram illustrating that the detection resistor network is grounded according to an embodiment of the present disclosure.

One terminal of the first resistor R0 is connected to the source of S1 through a switch K, and the other terminal of the first resistor R0 is grounded.

The controller is further configured to control the switch K to be turned on when the insulation impedance is detected, and control the switch K to be turned off when the insulation impedance is not detected.

It should be understood that, the converter according to an embodiment of the present disclosure utilizes the first switch transistor and the second switch transistor which has been included in the power conversion circuit, and only one detection resistor network is required to be added, so that the cost is low and the structure is simple. By controlling the on/off state of the first switch transistor or the second switch transistor, the voltage between the direct-current positive electrode and the direct-current negative electrode of the converter or the voltage between the direct-current negative electrode and the ground can be changed, and then the insulation impedance of the converter can be obtained based on the resistance value of the first resistor.

The first resistor is connected to the positive electrode of the direct-current power supply through the first switch transistor, and connected to the negative electrode of the direct-current power supply through the second switch transistor. Thus, when the on/off state of the first switch transistor or the second switch transistor changes, the positive half cycle and the negative half cycle of common mode voltage on the bus is disturbed, that is, the disturbed voltage range is relatively large. Thus, the detection for the insulation impedance becomes more sensitive.

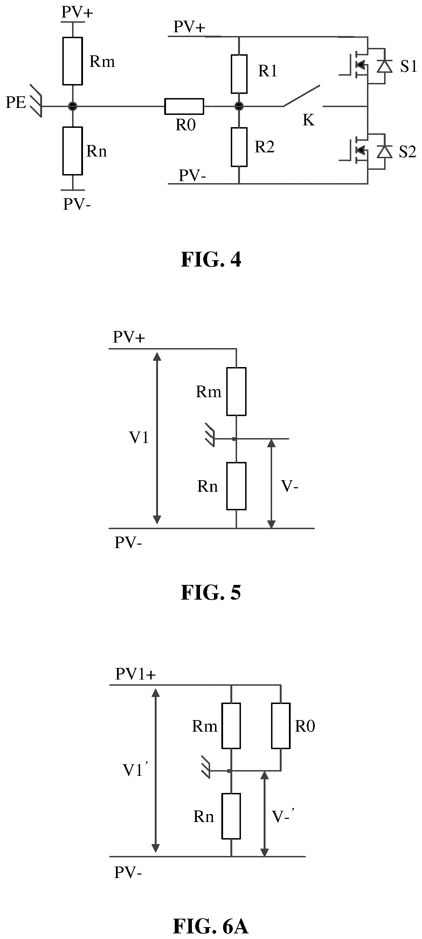

Referring to FIG. 4, a schematic diagram of a detection resistor network is shown according to another embodiment of another present disclosure.

The converter according to the present embodiment will continue to be introduced by taking application in the photovoltaic field as an example.

The detection resistor network further includes: a second resistor R1 and a third resistor R2.

It should be noted that the advantage of the multiple resistors in FIG. 4 over the single resistor in FIG. 3 is that it facilitates the puncture test.

Two terminals of the second resistor R1 are respectively connected to the positive electrode PV+ of the direct-current power supply and the second terminal of the first switch transistor S1.

Two terminals of the third resistor R2 are respectively connected to the negative electrode PV- of the direct-current power supply and the second terminal of the first switch transistor S1.

Similar to the switch K in FIG. 3, the detection resistor network in FIG. 4 may also correspond to the switch K. That is, one terminal of the first resistor R0 is connected to the source of S1 through the switch K, and the other terminal of the first resistor R0 is connected to the ground PE.

FIG. 2 shows that the first resistor is directly grounded. In another implementation, a common terminal of two switch transistors is grounded through an inductor in a filter circuit and the first resistor.

Hereinafter, the detection principle of the insulation impedance according to the embodiments of the present disclosure is described in detail with reference to the drawings.

The voltage can be disturbed by turning on the first switch transistor or the second switch transistor, which will not be specifically limited in the embodiment of the present disclosure. Hereinafter, the first switch transistor being turned on is taken as an example for introduction.

Scheme 1:

Referring to FIG. 5, an equivalent circuit diagram corresponding to a situation that both S1 and S2 in FIG. 2 are turned off.

In FIG. 2, the source of S1 is connected to the drain of S2. The drain of S1 is connected to the PV+ and one terminal of the resistor Rm. The other terminal of Rm is connected to the casing PE and one terminal of Rn. The other terminal of Rn is connected to PV-. One terminal of R0 is connected to the casing PE, and the other terminal of R0 is connected to the source of S1. Rm is an equivalent impedance between PV+ and PE, and Rn is an equivalent impedance between PV- and PE. The voltage between PV+ and PV- is represented by V1, and the voltage between PV- and the ground is represented by V-.

Referring to FIG. 6A, an equivalent circuit diagram corresponding to a situation that S1 in FIG. 2 is turned on and S2 in FIG. 2 is turned off.

After S1 is turned on and S2 is turned off, R0 is connected in parallel with Rn. In this condition, the voltage between PV1+ and PV- is represented by V1', and the voltage between PV- and PE is represented by V-'.

It is assumed that the voltage between PV+ and PV- is unchanged before and after S1 is turned on, that is, V1 = V1'.

The node current equations for FIG. 5 and FIG. 6A are obtained respectively as following formulas (1) and (2):

$$\frac{V_1 - V_-}{R_m} = \frac{V_-}{R_n} \qquad (1)$$

$$\frac{V_1 - V_-'}{R_m \| R_0} = \frac{V_-'}{R_n} \qquad (2)$$

Formula (3) is obtained, by subtracting the formula (1) from the formula (2) to obtain a result and organizing the result;

$$\frac{V_1 - V_-'}{R_0} + \left( V_-' - V_- \right) \left( \frac{1}{R_m} + \frac{1}{R_n} \right) = 0 \quad (3)$$

For further optimization, an impedance of the machine to PE is represented by Riso. By substituting that $\frac{1}{R_{iso}} = \frac{1}{R_m} + \frac{1}{R_n}$ into formula (3), the following formula can be obtained:

$$R_{iso} = \frac{\left( V_-' - V_- \right) R_0}{\left( V_- - V_1 \right)}$$

Scheme 2

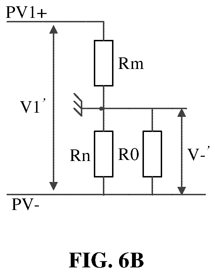

In this scheme, the situation that the second switch transistor S2 is controlled to be turned on is taken as an example. The equivalent diagram of the situation that both switch transistors are turned off is shown in FIG. 5, and an equivalent circuit diagram of a situation that S2 is turned on is shown in FIG. 6B.

In the situation that S1 is turned off and S2 is turned on, the equivalent circuit of FIG. 2 is shown in FIG. 6B, R0 and Rn are connected in parallel. In this condition, the impedance between PV1+ and PV- is V1', and the voltage between PV- and PE is V-'.

It is assumed that the voltage between PV+ and PV- is unchanged before and after the transistor is turned on, that is, V1 = V1'. The node current equations for FIG. 5 and FIG. 6B are respectively obtained as the following formulas (1) and (2):

$$\frac{V_1 - V_-}{R_m} = \frac{V_-}{R_n} \qquad (4)$$

$$\frac{V_1 - V_-'}{R_m} = \frac{V_-'}{R_n || R_0} \qquad (5)$$

Formula (6) is obtained, by subtracting the formula (4) from the formula (5) to obtain a result and organizing the result;

$$\left( V_-' - V_- \right) \left( \frac{1}{R_m} + \frac{1}{R_n} \right) + \frac{V_-'}{R_0} = 0 \qquad (6)$$

For further optimization, the insulation impedance is represented by Riso. By substituting that $\frac{1}{R_{iso}} = \frac{1}{R_m} + \frac{1}{R_n}$ into formula (6), the following formula can be obtained:

$$R_{iso} = \frac{\left( V_- - V_-' \right) R_0}{V_-'}.$$

It should be understood that for the detection circuit network shown in FIG. 4, the state of S1 or S2 may be controlled by the above-described manner to establish a corresponding formula, to obtain the insulation impedance.

It should be understood that after the insulation impedance of the converter is obtained, whether the converter has an insulation fault to the ground may be determined based on the value of the insulation impedance. For example, the insulation impedance may be compared with a preset value. If the insulation impedance is less than the preset value, it indicates that the insulation fault has occurred, the number of insulation abnormalities is recorded. If the number of insulation abnormalities exceeds a preset abnormality number, an alarm is issued and a shutdown is performed.

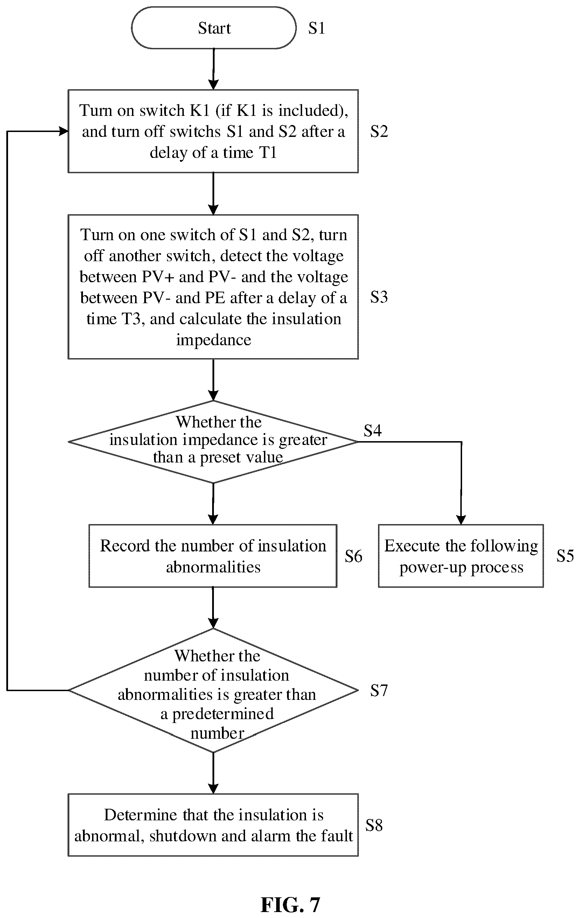

The following describes in detail a specific process of obtaining an insulation impedance by a converter according to an embodiment of the present disclosure. The process is shown as FIG 7.

In step S1, the process is started.

In step S2, a switch K is turned on (including switch K shown in FIG. 2), and S1 and S2 are turned off after a delay of a time T1.

In step S3, one switch of S1 and S2 is turned on, another switch is turned off, and the voltage between PV+ and PV- and the voltage between PV- and PE are detected after a delay of a time T3, and an insulation impedance is calculated for the system.

In step S4, whether the insulation impedance is greater than a preset value is determined.

In step S5, in response to the insulation impedance not greater than the preset value in step S4, the following power-up process is executed.

In step S6, in response to the insulation impedance greater than the preset value in step S4, the number of insulation abnormalities is recorded.

In step S7, whether the number of insulation abnormalities is greater than a predetermined number is determined.

In step S8, in response to the number of insulation abnormalities greater than the predetermined value in step S7, it is determined that the insulation is abnormal, and then the shutdown is performed and the fault is alarmed.

Hereinafter, the method for obtaining the insulation impedance is introduced in combination with several specific converters.

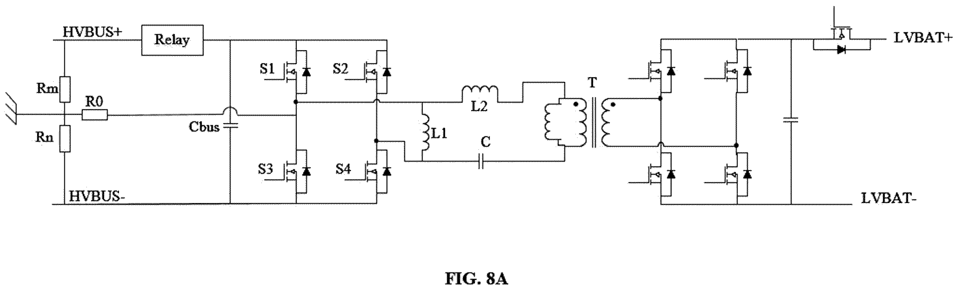

Referring to FIG. 8A, a schematic diagram of an isolated DCDC converter is shown according to an embodiment of the present disclosure.

In this embodiment, an LLC resonant isolated DCDC converter is introduced as an example, and the application scenario is not specifically limited herein. For example, the input is on the high-voltage side, where HVBUS+ is a positive electrode of the high-voltage side, and HVBUS- is a negative electrode of the high-voltage side. The output is on the low-voltage side, where LVBAT+ is a positive electrode of the low-voltage side and LVBAT-is a negative electrode of the low-voltage side. The direct-current power supply connected to the high-voltage side may be a battery.

A high-voltage full bridge at a primary side includes two bridge arms connected in parallel. The left bridge arm includes switch transistors S1 and S3 connected in series, and the right bridge arm includes switch transistors S2 and S4 connected in series. A first terminal of the transformer T on the primary side is connected to a midpoint of the left bridge arm (that is, the common terminal of S1 and S3) through an inductor L2. A second terminal of the transformer T on the primary side is connected to a midpoint of the right bridge arm (that is, the common terminal of S2 and S4) through a capacitor C.

The first resistor R0 is directly connected between the midpoint of the left bridge arm of the high-voltage full bridge on the primary side (that is, the common terminal of S1 and S3) and the ground PE. R0 can be flexibly connected to Rm or Rn in parallel by adjusting the on/off state of the upper transistor S1 and the lower transistor S3, so that the insulation impedance of the converter to the ground on the direct-current side can be obtained.

In FIG. 8A, the first resistor is connected between the common terminal of two switch transistors and the ground. In another implementation, the first resistor may be connected between the inductor and the ground, which will be described in detail below with reference to the drawings.

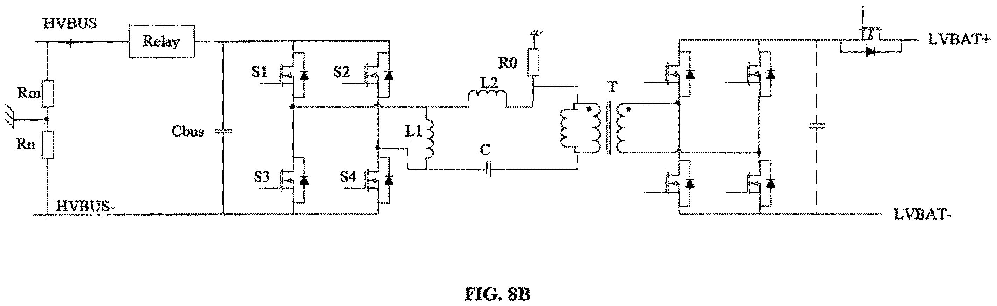

Referring to FIG. 8B, a schematic diagram of an isolated DCDC converter is shown according to another embodiment of the present disclosure.

The first resistor R0 is connected between the inductor L2 of the LLC resonant network at the primary side and the ground PE. R0 can be flexibly connected to Rm or Rn in parallel by adjusting the on/off state of the upper transistor S1 and the lower transistor S3 (or S2 and S4), thereby obtaining the insulation impedance by the method of obtaining the insulation impedance described above.

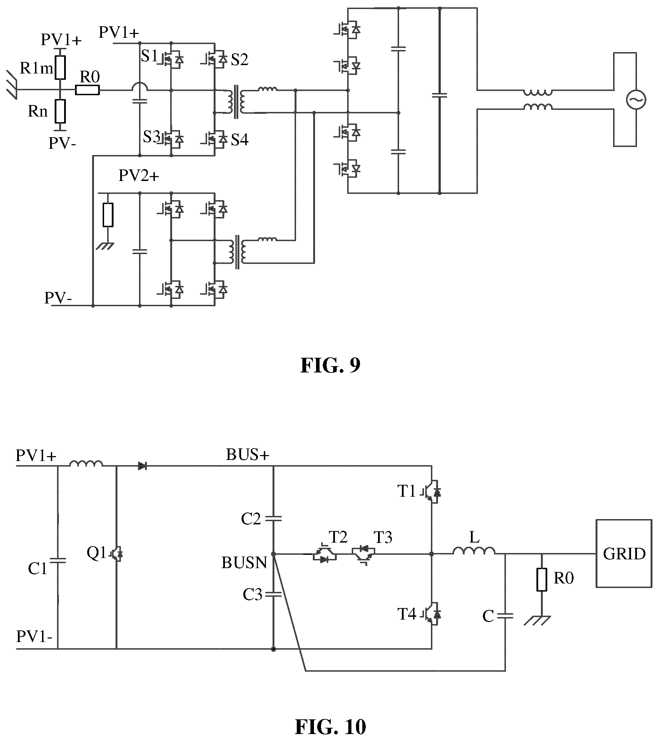

Referring to FIG. 9, a schematic diagram of an isolated DCAC converter is shown according to an embodiment of the present disclosure.

The inverter shown in FIG. 9 is a kind of micro-inverter, the primary side is a full-bridge converter, and the secondary side is an alternating current converter. The full-bridge converter at the primary side includes two bridge arms connected in parallel, the left bridge arm includes switch transistors S1 and S3 connected in series, and the right bridge arm includes switch transistors S2 and S4 connected in series.

The number of channels on the primary side of the micro-inverter is not specifically limited in the embodiment of the present disclosure. The number of channels may be one or more. For example, in the case that the primary side of the micro-inverter includes more than one channel, each channel may be connected to a corresponding photovoltaic array. FIG. 9 takes the primary side including multiple full-bridge converters as an example. The multiple full-bridge converters may correspond to multiple transformers, and the output terminals of the secondary side are connected in parallel.

The first resistor R0 is directly connected between the midpoint (that is, the common terminal of S1 and S3) of the left bridge arm of the full bridge on the primary side and the ground PE. R0 can be flexibly connected to Rm or Rn in parallel by adjusting the on/off state of the upper transistor S1 or the lower transistor S3, thereby obtaining the insulation impedance by the method of obtaining the insulation impedance described above.

Referring to Figure 10, a schematic diagram of a T-type three-level converter is shown according to an embodiment of the present disclosure.

In this embodiment, the converter being an inverter is taken as an example.

Only one phase of the T-type three-level inverter is illustrated in FIG. 10. The output terminal of the T-type three-level converter is connected with an LC filter circuit which includes an inductor L and a capacitor C.

The first resistor R0 is connected between the inductor L in the filter circuit of the T-type three-level inverter and the ground. The horizontal transistor of the T-type three-level inverter includes T2 and T3, and the longitudinal transistor includes T1 and T4. T1 and T4 correspond to S1 and S2 in FIG. 2 respectively. After T1 or T4 is turned on, the corresponding formula may be derived, to obtain the insulation impedance.

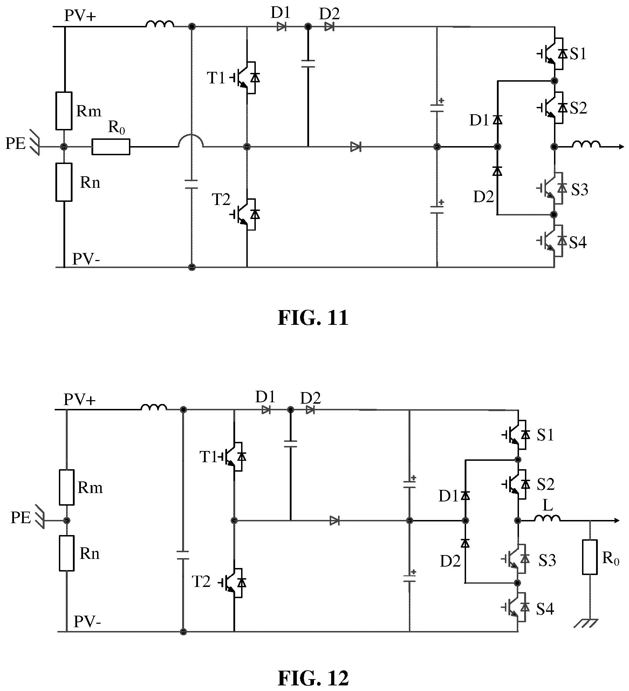

Referring to FIG. 11, a schematic diagram of a three-level Boost+NPC converter is shown according to an embodiment of the present disclosure.

In this embodiment, the converter being an inverter is also taken as an example.

In the topology of the three-level floating BOOST+NPC inverter, R0 is directly connected between the ground PE and the midpoint of the upper transistor T1 and the lower transistor T2 (that is, the source of the transistor T1). T1 and T2 correspond to S1 and S2 in FIG. 2 respectively. R0 can be flexibly connected to Rm or Rn in parallel by adjusting the on/off state of the upper transistor S1 or the lower transistor S3, thereby obtaining the insulation impedance by the method of obtaining the insulation impedance described above.

In addition, in the converter according to the embodiment of the present disclosure, the first resistor R0 may be connected between the inductor L and the ground PE, as shown in FIG. 12. Referring to FIG. 12, a schematic diagram of a three-level Boost+NPC converter is shown according to another embodiment of the present disclosure.

S1, S2, S3, and S4 are controlled to be turned on and off separately, so as to obtain the insulation impedance by the method of obtaining the insulation impedance described above.

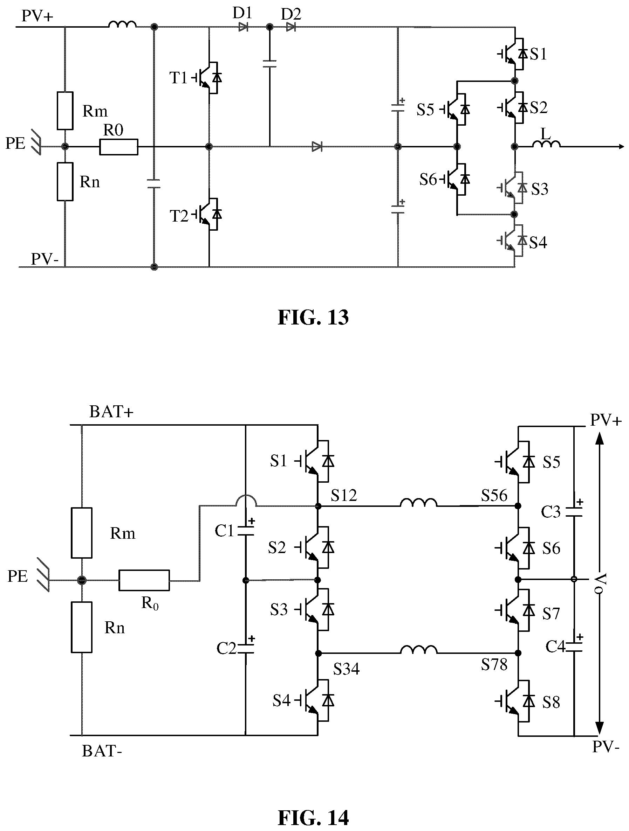

Referring to FIG. 13, a schematic diagram of a three-level Boost+ANPC converter is shown according to an embodiment of the present disclosure.

The difference between FIG. 13 and FIG. 11 is that clamping transistors in FIG. 11 are diodes, namely D1 and S2, and the clamping transistors in FIG. 13 are controllable switch transistors, namely S5 and S6. For the converter in FIG. 13, the configuration of the first resistor may be referred to FIG. 11 and FIG. 12, which will not be repeated herein.

Referring to FIG. 14, a schematic diagram of a bidirectional DCDC buck-boost converter is shown according to an embodiment of the present disclosure.

The bidirectional DCDC buck-boost converter according to the embodiment includes a first switching module S1, a second switching module S2, a third switching module S3, and a fourth switching module S4 which are sequentially connected in series. In this embodiment, each switching module including one switch transistor is taken as an example.

The first switch transistor and the second switch transistor in FIG. 1 correspond to the first switching module and the second switching module in FIG. 14, respectively.

As shown in FIG. 14, a common terminal of the first switching module S1 and the second switching module S2 are grounded through the first resistor R0.

In the bidirectional DCDC buck-boost converter according to this embodiment, the first resistor R0 is connected between PE and the midpoint of the two transistors S1 and S2 (the source of the S1 device), that is, between the point S12 and PE. S1 and S2 are separately controlled to be turned on and off, so that the impedance loop of the system to the ground is reconstructed, thereby calculating the value of the insulation impedance of the system to the ground. The first resistor R0 may also be connected between PE and the midpoint of the two transistors S3 and S4, that is, between the point S34 and PE. Alternatively, the first resistor R0 may be connected between PE and the midpoint of the two transistors S5 and S6, that is, between the point S56 and PE. Alternatively, the first resistor R0 may be connected between PE and the midpoint of the two transistors S7 and S8, that is, between the point S78 and PE.

The following introduces several implementations in which the converter is a heric converter.

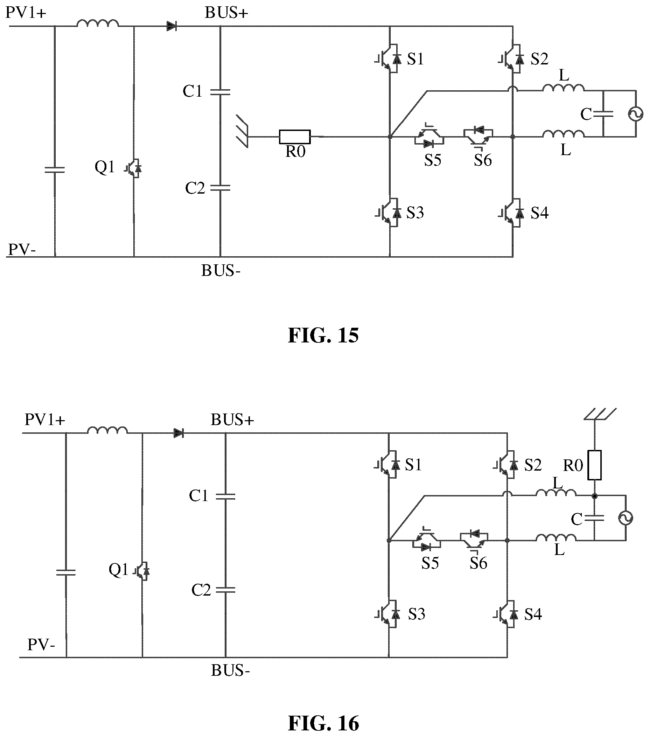

Referring to FIG. 15, a schematic diagram of a heric converter is shown according to an embodiment of the present disclosure.

In FIG. 15, the first resistor R0 is connected between the ground and the common terminal of S1 and S3.

Referring to FIG. 16, a schematic diagram of a heric converter is shown according to another embodiment of the present disclosure.

In FIG. 16, the first resistor R0 is connected between the inductor L and the ground.

For the converter shown in FIGS. 15 and 16, the insulation impedance may be obtained by the following operation: turning on S1 and turning off other switches; and turning on S3 and turning off other switches.

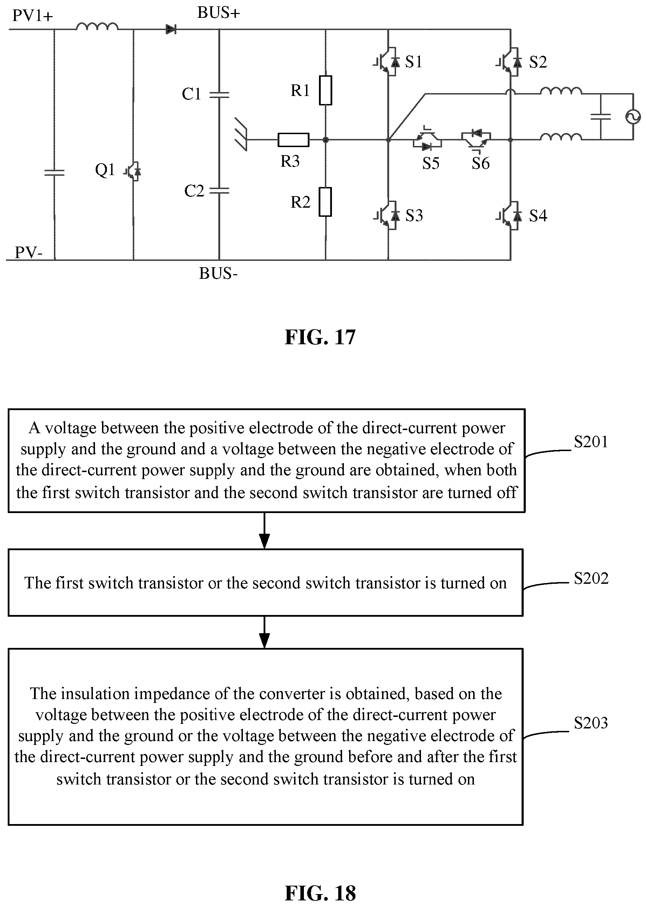

Referring to FIG. 17, a schematic diagram of a heric converter is shown according to yet another embodiment of the present disclosure.

It is assumed that the insulation impedance of the positive electrode of PV to the ground is Rm, the insulation impedance of the negative electrode of PV to the ground is Rn, and R1, R2 and R3 are additional resistors.

R1, R2, and R3 are crossed over at the post stage of the bus. One terminal of R1 is connected to BUS+, the other terminal is connected to point N, one terminal of R2 is connected to BUS-, the other terminal is connected to point N, one terminal of R3 is connected to PE, and the other terminal is connected to point N. The source of switch S1 is connected to point N and the drain of S3.

The converter according to the embodiment of the present disclosure can obtain the impedance to the ground at the direct-current side in a simple manner. The converter may have various types. The type of the converter is not specifically limited, for example, it may be a micro inverter, a string inverter, a DCDC converter, an energy storage converter, or a centralized inverter.

Based on the converter according to the above embodiments, a method for detecting an insulation impedance of a converter is further provided according to an embodiment of the present disclosure, which is described in detail below in conjunction with the drawings.

Referring to FIG. 18, a flowchart of a method for detecting an insulation impedance of a converter is shown according to an embodiment of the present disclosure.

For the method for detecting the insulation impedance of the converter according to the present embodiment, the converter includes: a detection resistor network and a power conversion circuit. The power conversion circuit includes a first switch transistor and a second switch transistor. A first terminal of the first switch transistor is connected to a positive electrode of a direct-current power supply, a second terminal of the first switch transistor is connected to a first terminal of the second switch transistor, and a second terminal of the second switch transistor is connected to a negative electrode of the direct-current power supply. The second terminal of the first switch transistor is grounded through the detection resistor network.

The method further includes steps S201 to S203.

In step S201, a voltage between the positive electrode and the negative electrode of the direct-current power supply and a voltage between the negative electrode of the direct-current power supply and the ground are obtained, when both the first switch transistor and the second switch transistor are turned off.

In step S202, the first switch transistor or the second switch transistor is turned on.

In step S203, the insulation impedance of the converter is obtained based on the voltage between the positive electrode and the negative electrode of the direct-current power supply and the voltage between the negative electrode of the direct-current power supply and the ground before and after the first switch transistor or the second switch transistor is turned on.

The order of S201 and S202 is not specifically limited in the embodiment of the present disclosure.

In the method for detecting the insulation impedance of the converter according to the present disclosure, only one detection resistor network is required to be added to the converter. The converter includes the first switch transistor and the second switch transistor connected in series. The second terminal of the first switch transistor is grounded through the detection resistor network. By controlling the on/off state of the first switch transistor or the second switch transistor, the voltage between the direct-current positive electrode and the direct-current negative electrode of the converter and the voltage between the direct-current negative electrode and the ground can be changed, and then the insulation impedance of the converter can be obtained based on the impedance of the detection resistor network. The insulation impedance of the converter can be detected by a simple structure, so that the cost is low. The structure of the converter for detecting insulation impedance suitable for various types of converters.

The detection resistor network may include one or more resistors, which are described separately below.

In a first condition, the detection resistor network includes a first resistor, the second terminal of the first switch transistor is grounded through the first resistor.

In a second condition, the detection resistor network further includes: a second resistor and a third resistor, besides the first resistor.

Two terminals of the second resistor are respectively connected to the positive electrode of the direct-current power supply and the second terminal of the first switch transistor.

Two terminals of the third resistor are respectively connected to the negative electrode of the direct-current power supply and the second terminal of the first switch transistor.

Either the first switch transistor or the second switch transistor may be controlled to be turned on, and the implementation methods are described below.

Scheme 1

The step of obtaining the insulation impedance of the converter, based on the voltage between the positive electrode and the negative electrode of the direct-current power supply and the voltage between the negative electrode of the direct-current power supply and the ground before and after the first switch transistor or the second switch transistor is turned on includes: obtaining the insulation impedance of the converter, based on the voltage between the positive electrode and the negative electrode of the direct-current power supply and the voltage between the negative electrode of the direct-current power supply and the ground before the first switch transistor is turned on, and the voltage between the negative electrode of the direct-current power supply and the ground after the first switch transistor is turned on.

Scheme 2

The step of obtaining the insulation impedance of the converter, based on the voltage between the positive electrode and the negative electrode of the direct-current power supply and the voltage between the negative electrode of the direct-current power supply and the ground before and after the first switch transistor or the second switch transistor is turned on includes: obtaining the insulation impedance of the converter, based on the voltage between the positive electrode and the negative electrode of the direct-current power supply and the voltage between the negative electrode of the direct-current power supply and the ground before the second switch transistor is turned on, and the voltage between the negative electrode of the direct-current power supply and the ground after the second switch transistor is turned on.

It should be noted that the embodiments in the present disclosure are described in a progressive manner, and each of the embodiments focuses on its differences from the other embodiments. The same and similar parts among the embodiments may be referred to each other. The system or device disclosed in the embodiments correspond to the method disclosed in the embodiments, and therefore are described in a relatively simple way. Reference may be made to the description of the method for relevant details.

The disclosed embodiments are described above so that those skilled in the art can implement or use the present disclosure. It is obvious for those skilled in the art to make multiple modifications to these embodiments. The general principle defined herein may be applied to other embodiments without departing from the spirit or scope of the present disclosure. Therefore, the present disclosure is not limited to the embodiments described herein, but should be in accordance with the widest scope consistent with the principle and novel features disclosed herein.

**Claims**

1. A converter, comprising: a controller, a detection resistor network, and a power conversion circuit; wherein

   the power conversion circuit comprises a first switch transistor and a second switch transistor;
   a first terminal of the first switch transistor is connected to a positive electrode of a direct-current power supply, a second terminal of the first switch transistor is connected to a first terminal of the second switch transistor, and a second terminal of the second switch transistor is connected to a negative electrode of the direct-current power supply; the second terminal of the first switch transistor is grounded through the detection resistor network; and
   the controller is configured to obtain an insulation impedance of the converter, based on a voltage between the positive electrode and the negative electrode of the direct-current power supply and a voltage between the negative electrode of the direct-current power supply and ground before and after the first switch transistor or the second switch transistor is turned on.

2. The converter according to claim 1, wherein the detection resistor network comprises a first resistor; and
   the second terminal of the first switch transistor is grounded through the first resistor.

3. The converter according to claim 2, wherein the detection resistor network further comprises: a second resistor and a third resistor,

   two terminals of the second resistor are respectively connected to the positive electrode of the direct-current power supply and the second terminal of the first switch transistor; and
   two terminals of the third resistor are respectively connected to the negative electrode of the direct-current power supply and the second terminal of the first switch transistor.

4. The converter according to claim 2 or 3, wherein the converter further comprises an inductor;
   the second terminal of the first switch transistor is grounded, through the inductor and the first resistor connected in series.

5. The converter according to any one of claims 1 to 4, wherein the controller is configured to obtain the insulation impedance of the converter, based on the voltage between the positive electrode and the negative electrode of the direct-current power supply and the voltage between the negative electrode of the direct-current power supply and the ground before the first switch transistor is turned on, and the voltage between the negative electrode of the direct-current power supply and the ground after the first switch transistor is turned on.

6. The converter according to any one of claims 1 to 4, wherein the controller is configured to obtain the insulation impedance of the converter, based on the voltage between the positive electrode and the negative electrode of the direct-current power supply and the voltage between the negative electrode of the direct-current power supply and the ground before the second switch transistor is turned on, and the voltage between the negative electrode of the direct-current power supply and the ground after the second switch transistor is turned on.

7. The converter according to any one of claims 1 to 6, wherein the converter is an isolated DCDC converter or an isolated DCAC converter; and
   the first switch transistor and the second switch transistor are two switch transistors in a first bridge arm of a full bridge at a primary side of the isolated DCDC converter or two switch transistors in a first bridge arm of a full bridge at a primary side of the isolated DCAC converter; and the full bridge at the primary side of the isolated DCDC converter comprises the first bridge arm and a second bridge arm.

8. The converter according to any one of claims 1 to 6, wherein the converter is a T-type three-level inverter;

   the T-type three-level inverter further comprises an inductor; and
   the second terminal of the first switch transistor is grounded, through the inductor and the detection resistor network connected in series.

9. The converter according to any one of claims 1 to 6, wherein the converter comprises a three-level Boost circuit and a neutral-point clamped inverter circuit; wherein the neutral-point clamped inverter circuit comprises a first switching module, a second switching module, a third switching module and a fourth switch module which are connected in series; and

the first switch transistor and the second switch transistor are a first switching module and a second switching module of the three-level Boost circuit, respectively; or the first switch transistor and the second switch transistor are the second switching module and the third switching module of the neutral-point clamped inverter circuit.

10. The converter according to any one of claims 1 to 6, wherein the converter comprises a three-level Boost circuit and an active neutral-point clamped inverter circuit; and
the first switch transistor and the second switch transistor are a first switch transistor and a second switch transistor of the three-level Boost circuit, respectively.

11. The converter according to any one of claims 1 to 6, wherein the converter is a bidirectional DCDC buck-boost converter;

the bidirectional DCDC buck-boost converter comprises a first switching module, a second switching module, a third switching module and a fourth switching module which are sequentially connected in series;
the first switch transistor and the second switch transistor are the first switching module and the second switching module, respectively; and
a common terminal of the first switching module and the second switching module is grounded through the detection resistor network.

12. The converter according to any one of claims 1 to 6, wherein the converter is a heric converter;

the heric converter comprises a first bridge arm, a second bridge arm, a fifth switching module, a sixth switching module, and an LC filter; a midpoint of the first bridge arm is grounded through the detection resistor network;
the fifth switching module and the sixth switching module are connected in series between the midpoint of the first bridge arm and a midpoint of the second bridge arm; and
a first terminal and a second terminal of the LC filter are connected to the midpoint of the first bridge arm and the midpoint of the second bridge arm, respectively; and the first terminal and the second terminal of the LC filter are connected to two terminals of a capacitor through a first inductor and a second inductor, respectively.

13. The converter according to any one of claims 1 to 6, wherein the converter is a heric converter;

the heric converter comprises a first bridge arm, a second bridge arm, a fifth switching module, a sixth switching module, and an LC filter;
the fifth switching module and the sixth switching module are connected in series between a midpoint of the first bridge arm and a midpoint of the second bridge arm;
a first terminal and a second terminal of the LC filter are connected to the midpoint of the first bridge arm and the midpoint of the second bridge arm, respectively; and the first terminal and the second terminal of the LC filter are connected to two terminals of a capacitor through a first inductor and a second inductor, respectively;
the first terminal of the LC filter is grounded, through the first inductor and a first resistor connected in series; and
the first switch transistor and the second switch transistor are two switch transistors in the first bridge arm.

14. The converter according to any one of claims 1 to 13, wherein the converter further comprises: a switch;

the detection resistor network is grounded through the switch; and
the controller is further configured to control the switch to be turned on when the insulation impedance is detected, and control the switch to be turned off when the insulation impedance is not detected.

15. The converter according to any one of claims 1 to 14, wherein the direct-current power supply is a photovoltaic array or a battery.

16. A method for detecting an insulation impedance of a converter, wherein the converter comprises: a detection resistor network and a power conversion circuit; the power conversion circuit comprises a first switch transistor and a second switch transistor; a first terminal of the first switch transistor is connected to a positive electrode of a direct-current power supply, a second terminal of the first switch transistor is connected to a first terminal of the second switch transistor, and a second terminal of the second switch transistor is connected to a negative electrode of the direct-current power supply; the second terminal of the first switch transistor is grounded through the detection resistor network; and
the method further comprises:

obtaining a voltage between the positive electrode and the negative electrode of the direct-current power supply and a voltage between the negative electrode of the direct-current power supply and ground, when both the first switch transistor and the second switch transistor are turned off;

turning on the first switch transistor or the second switch transistor; and

obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on.

17. The method according to claim 16, wherein the detection resistor network comprises a first resistor; and the second terminal of the first switch transistor is grounded through the first resistor.

18. The method according to claim 16, wherein the detection resistor network further comprises: a second resistor and a third resistor, wherein

two terminals of the second resistor are respectively connected to the positive electrode of the direct-current power supply and the second terminal of the first switch transistor; and

two terminals of the third resistor are respectively connected to the negative electrode of the direct-current power supply and the second terminal of the first switch transistor.

19. The method according to claim 17 or 18, wherein the obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on comprises:

obtaining the insulation impedance of the converter, based on the voltage between the positive electrode and the negative electrode of the direct-current power supply and the voltage between the negative electrode of the direct-current power supply and the ground before the first switch transistor is turned on, and the voltage between the negative electrode of the direct-current power supply and the ground after the first switch transistor is turned on.

20. The method according to claim 17 or 18, wherein the obtaining an insulation impedance of the converter, based on the voltage between the positive electrode and the negative electrode of the direct-current power supply and the voltage between the negative electrode of the direct-current power supply and the ground before and after the first switch transistor or the second switch transistor is turned on comprises:

obtaining the insulation impedance of the converter, based on the voltage between the positive electrode and the negative electrode of the direct-current power supply and the voltage between the negative electrode of the direct-current power supply and the ground before the second switch transistor is turned on, and the voltage between the negative electrode of the direct-current power supply and the ground after the second switch transistor is turned on.

**FIG. 1**

**FIG. 2**

**FIG. 3**

**FIG. 4**

**FIG. 5**

**FIG. 6A**

**FIG. 6B**

Start $\quad$ S1

Turn on switch K1 (if K1 is included), and turn off switchs S1 and S2 after a delay of a time T1 $\quad$ S2

Turn on one switch of S1 and S2, turn off another switch, detect the voltage between PV+ and PV- and the voltage between PV- and PE after a delay of a time T3, and calculate the insulation impedance $\quad$ S3

Whether the insulation impedance is greater than a preset value $\quad$ S4

Record the number of insulation abnormalities $\quad$ S6

Execute the following power-up process $\quad$ S5

Whether the number of insulation abnormalities is greater than a predetermined number $\quad$ S7

Determine that the insulation is abnormal, shutdown and alarm the fault $\quad$ S8

FIG. 7

FIG. 8A

**FIG. 8B**

**FIG. 9**

**FIG. 10**

**FIG. 11**

**FIG. 12**

**FIG. 13**

**FIG. 14**

**FIG. 15**

**FIG. 16**

**FIG. 17**

A voltage between the positive electrode of the direct-current power supply and the ground and a voltage between the negative electrode of the direct-current power supply and the ground are obtained, when both the first switch transistor and the second switch transistor are turned off — S201

The first switch transistor or the second switch transistor is turned on — S202

The insulation impedance of the converter is obtained, based on the voltage between the positive electrode of the direct-current power supply and the ground or the voltage between the negative electrode of the direct-current power supply and the ground before and after the first switch transistor or the second switch transistor is turned on — S203

**FIG. 18**

## INTERNATIONAL SEARCH REPORT

| International application No. |
| --- |
| **PCT/CN2023/113933** |

**A.    CLASSIFICATION OF SUBJECT MATTER**

H02M7/162(2006.01)i;  H02M3/335(2006.01)i;  H02M7/5387(2007.01)i;  H02M1/088(2006.01)i;  G01R27/02(2006.01)i

According to International Patent Classification (IPC) or to both national classification and IPC

**B.    FIELDS SEARCHED**

Minimum documentation searched (classification system followed by classification symbols)

IPC:H02M; G01R

Documentation searched other than minimum documentation to the extent that such documents are included in the fields searched

Electronic data base consulted during the international search (name of data base and, where practicable, search terms used)

CNTXT, CNABS, CNKI, EPTXT, WOTXT, USTXT, VEN: 变换器, 变流器, 绝缘电阻, 绝缘阻抗, 逆变, 整流, converter, insulated resistance, insulated impedance, inversion, rectification

**C.    DOCUMENTS CONSIDERED TO BE RELEVANT**

| Category* | Citation of document, with indication, where appropriate, of the relevant passages | Relevant to claim No. |
| --- | --- | --- |
| X | CN 112083230 A (AISWEI NEW ENERGY TECHNOLOGY (JIANGSU) CO., LTD.) 15 December 2020 (2020-12-15)<br>    description, paragraphs 0005-0066, and figures 2-3 | 1-20 |
| X | CN 112083229 A (AISWEI NEW ENERGY TECHNOLOGY (JIANGSU) CO., LTD.) 15 December 2020 (2020-12-15)<br>    description, paragraphs 0005-0066, and figures 2-3 | 1-20 |
| X | CN 112379171 A (JIANGSU WEIHENG INTELLIGENT TECHNOLOGY CO., LTD.) 19 February 2021 (2021-02-19)<br>    description, paragraphs 0035-0053, and figures 2-4 | 1-20 |
| A | CN 106324359 A (ZTE CORP.) 11 January 2017 (2017-01-11)<br>    entire document | 1-20 |
| A | JP 2009031187 A (FUJI ELECTRIC SYSTEMS CO., LTD.) 12 February 2009 (2009-02-12)<br>    entire document | 1-20 |
| A | US 2015084654 A1 (SMA SOLAR TECHNOLOGY AG.) 26 March 2015 (2015-03-26)<br>    entire document | 1-20 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **09 October 2023** | **16 October 2023** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2023/113933** |

| Patent document cited in search report | | | Publication date (day/month/year) | Patent family member(s) | | | Publication date (day/month/year) |
| --- | --- | --- | --- | --- | --- | --- | --- |
| CN | 112083230 | A | 15 December 2020 | None | | | |
| CN | 112083229 | A | 15 December 2020 | None | | | |
| CN | 112379171 | A | 19 February 2021 | None | | | |
| CN | 106324359 | A | 11 January 2017 | WO | 2016206488 | A1 | 29 December 2016 |
| JP | 2009031187 | A | 12 February 2009 | JP | 5003333 | B2 | 15 August 2012 |
| US | 2015084654 | A1 | 26 March 2015 | JP | 2015529440 | A | 05 October 2015 |
| | | | | JP | 6168319 | B2 | 26 July 2017 |
| | | | | EP | 2856192 | A1 | 08 April 2015 |
| | | | | EP | 2856192 | B1 | 02 August 2017 |
| | | | | US | 9797853 | B2 | 24 October 2017 |
| | | | | WO | 2013178654 | A1 | 05 December 2013 |
| | | | | DE | 102012104752 | B3 | 28 November 2013 |
| | | | | CN | 104520726 | A | 15 April 2015 |
| | | | | IN | 397288 | B | 27 May 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310239127